# EUROPEAN PATENT APPLICATION

(11) **EP 4 841 747 A1**
(43) Date of publication of application: **18.11.2026**
(21) Application number: 24930407.2
(22) Date of filing: 12.10.2024
(51) Int. Cl.: H01M 10/48

(54) **POWER BATTERY DIAGNOSIS CIRCUIT AND CONTROL METHOD THEREFOR, AND POWER BATTERY**

(30) Priority: 18.03.2024 CN 202410311247
(71) Applicant: Guangzhou Xiaopeng Motors Technology Co., Ltd., Guangzhou, Guangdong 510000 (CN)
(72) Inventor: YAO, Hang, Guangzhou, Guangdong 510000 (CN)
(74) Representative: Ran, Handong
(86) International application number: PCT/CN2024/124547
(87) International publication number: WO 2025/194749

(57) **Abstract**

A power battery diagnosis circuit and a control method therefor, and a power battery. The power battery diagnosis circuit comprises: an equalization module, an equalization diagnosis module, a sampling diagnosis module and a control module, wherein the equalization module and the equalization diagnosis module are both connected in parallel to an equalization switch in an equalization circuit, and the control module is separately connected to the equalization module, the equalization diagnosis module and the sampling diagnosis module. The control module is used for controlling the equalization switch to be in an on state during line diagnosis, such that the equalization module discharges, controlling the equalization switch to be in an off state after the equalization switch remains in the on state for a first preset time, and controlling the equalization diagnosis module and the sampling diagnosis module, so as to perform line diagnosis on a sampling branch and the equalization circuit.

## Description

### CROSS-REFERENCE TO RELATED APPLICATIONS

This application claims priority to Chinese Patent Application No. 2024103112479, entitled "Power battery diagnosis circuit and control method therefor, and power battery", and filed on March 18, 2024, which is incorporated herein by reference in its entirety.

### TECHNICAL FIELD

The present invention relates to the technical field of power batteries, and in particular to a diagnosis circuit for a power battery, a control method for a diagnosis circuit for a power battery, and a power battery.

### BACKGROUND

Currently, with the development trend toward 800 V and even higher power voltage platforms for electric vehicles, as well as the increasing power of inductive-load drive motors, voltage surge disturbances on a power battery bus have also increased significantly. These surge disturbances on the bus are transmitted through a cell sampling harness to a cell sampling board of the battery management system (BMS), causing sampling instability of the sampling board. Moreover, an excessively high surge may preferentially pass through a low-impedance equalization circuit via a sampling line, which can easily cause overvoltage damage to a built-in metal-oxide semiconductor field-effect transistor (MOSFET) on the equalization circuit of the sampling board, ultimately leading to over-discharge of the battery cells.

Such surges may propagate along cell sampling lines from the power battery bus of the high-voltage platform to the BMS cell sampling board, further affecting sampling errors, equalization functions, and open-circuit diagnosis of the sampling lines. However, effective countermeasures for high-voltage platform applications are currently scarce, and existing solutions are mostly implemented at the source or along the propagation path. In related art, considering the diversity of power battery loads and operating scenarios, eliminating surges at the source (i.e., at the power battery load side and the charging piles) incurs significant costs and is generally difficult to completely achieve in practical engineering practice. Along the propagation path, a transient voltage suppressor (TVS) is added to each sampling (equalization) channel to prevent surges from damaging a low-impedance equalization circuit, and in software, the sampling filtering duration is increased to yield relatively accurate cell sampling voltage values. These operations, however, on the one hand, lead to a sharp increase in component cost, and on the other hand, compromise the performance of the sampling function, resulting in prolonged sampling periods and poor real-time data performance.

### SUMMARY OF THE INVENTION

The present invention aims to solve, at least to some extent, one of the technical problems in the related art. To this end, a first objective of the present invention is to provide a diagnosis circuit for a power battery, which, during line diagnosis, first causes an equalization module to discharge via an equalization switch, and then performs line diagnosis on a sampling branch and an equalization circuit via an equalization diagnosis module and a sampling diagnosis module. This achieves stable sampling and low cost, shortens the sampling period, and improves protection capability and diagnostic reliability of the cell sampling board.

A second objective of the present invention is to provide a control method for a diagnosis circuit for a power battery.

A third objective of the present invention is to provide a power battery.

To achieve the above objectives, embodiments of a first aspect of the present invention provide a diagnosis circuit for a power battery. The diagnosis circuit for a power battery includes an equalization module, an equalization diagnosis module, a sampling diagnosis module and a control module. The equalization module and the equalization diagnosis module are both connected in parallel with an equalization switch in an equalization circuit, and the control module is connected to the equalization switch, the equalization diagnosis module and the sampling diagnosis module. The control module is configured to, during line diagnosis, control the equalization switch to be in a connected state such that the equalization module discharges, control the equalization switch to be disconnected after the equalization switch remains in the connected state for a first preset time, and control the equalization diagnosis module and the sampling diagnosis module to perform line diagnosis on a sampling branch and the equalization circuit.

According to the diagnosis circuit for a power battery of the embodiments of the present invention, during line diagnosis, the control module controls the equalization switch to be in a connected state such that the equalization module discharges, controls the equalization switch to be disconnected after the equalization switch remains in the connected state for a first preset time, and then controls the equalization diagnosis module and the sampling diagnosis module to perform line diagnosis on a sampling branch and the equalization circuit. In this way, during line diagnosis, the circuit first causes the equalization module to discharge via the equalization switch, and then performs line diagnosis on the sampling branch and the equalization circuit via the equalization diagnosis module and the sampling diagnosis module. This achieves stable sampling and low cost, shortens the sampling period, and improves protection capability and diagnostic reliability of the cell sampling board.

In addition, the diagnosis circuit for a power battery provided in the above embodiments of the present invention may further have the following additional technical features.

According to an embodiment of the present invention, the sampling diagnosis module includes a first switch and a first resistor. One end of the first switch is connected to a first sampling point of the sampling branch, and the other end of the first switch is connected to a second sampling point of the sampling branch via the first resistor.

According to an embodiment of the present invention, the equalization diagnosis module includes a second switch and a second resistor connected in series. One end of the second switch is connected to one end of the equalization switch, and the other end of the second switch is connected to the other end of the equalization switch via the second resistor.

According to an embodiment of the present invention, the control module is further configured to control the first switch to be in an "on" state, control the second switch to be in an "off" state, and perform line diagnosis based on a voltage value of the first resistor.

According to an embodiment of the present invention, the control module is further configured to control the first switch to be in an "off" state, control the second switch to be in an "on" state, and perform line diagnosis based on a voltage value of the second resistor.

According to an embodiment of the present invention, the equalization module includes an equalization capacitor. The equalization capacitor is connected in parallel with the equalization switch.

According to an embodiment of the present invention, a capacitance value of the equalization capacitor is determined by a surge voltage and heat generated when the surge voltage is applied to the equalization circuit.

According to an embodiment of the present invention, the first preset time is determined by an internal resistance of the equalization switch and the capacitance value of the equalization capacitor.

According to an embodiment of the present invention, the equalization switch is a metal-oxide semiconductor field-effect transistor (MOSFET).

To achieve the above objectives, embodiments of the second aspect of the present invention provide a control method for the above-described diagnosis circuit for a power battery. The method includes: when line diagnosis is performed on the power battery, controlling the equalization switch in the equalization circuit to be in a connected state such that the equalization module discharges, and controlling the equalization switch to be disconnected after the equalization switch remains in the connected state for the first preset time; and controlling the equalization diagnosis module and the sampling diagnosis module to perform line diagnosis on the sampling branch and the equalization circuit.

According to the control method for the diagnosis circuit for a power battery of the embodiments of the present invention, when line diagnosis is performed on the power battery of a sampling branch, the equalization switch in the equalization circuit is first controlled to be in a connected state such that the equalization module discharges; the equalization switch of the sampling branch is then controlled to be disconnected after the equalization switch of the sampling branch remains in the connected state for a first preset time; and subsequently the equalization diagnosis module and the sampling diagnosis module are controlled to perform line diagnosis on the sampling branch and the equalization circuit of the sampling branch. In this way, through the method, during line diagnosis, the equalization module is discharged via the equalization switch, and then line diagnosis is performed on the sampling branch and the equalization circuit via the equalization diagnosis module and the sampling diagnosis module. This achieves stable sampling and low cost, shortens the sampling period, and improves protection capability and diagnostic reliability of the cell sampling board.

To achieve the above objectives, embodiments of the third aspect of the present invention propose a power battery. The power battery includes at least one battery cell and an above-described diagnosis circuit correspondingly arranged for each of the at least one battery cell.

The power battery of the embodiments of the present invention, with the above diagnosis circuit, during line diagnosis, first causes the equalization module to discharge via the equalization switch, and then performs line diagnosis on the sampling branch and the equalization circuit via the equalization diagnosis module and the sampling diagnosis module. This achieves stable sampling and low cost, shortens the sampling period, and improves protection capability and diagnostic reliability of the cell sampling board.

Additional aspects and advantages of the present invention will be set forth in part in the following description, and in part will be obvious from the following description or may be learned by practice of the present invention.

### BRIEF DESCRIPTION OF THE DRAWINGS

FIG. 1 is a block diagram of a diagnosis circuit for a power battery provided in an embodiment of the present invention.
FIG. 2 is a topological schematic diagram of a diagnosis circuit for a power battery provided in an embodiment of the present invention.
FIG. 3 is an equivalent circuit diagram of an equalization switch in a disconnected state during line diagnosis according to an embodiment of the present invention.
FIG. 4 is a flowchart of a control method for a diagnosis circuit for a power battery provided in an embodiment of the present invention.
FIG. 5 is a block diagram of a power battery provided in an embodiment of the present invention.

### DETAILED DESCRIPTION

Embodiments of the present invention will be described in detail below, and examples of the embodiments are illustrated in the accompanying drawings. The same or similar reference numerals denote the same or similar elements or elements having the same or similar functions throughout the drawings. The embodiments described below with reference to the accompanying drawings are exemplary and are intended to explain the present invention and should not be construed as limiting the present invention.

A diagnosis circuit for a power battery, a control method for the diagnosis circuit for a power battery, and a power battery proposed in the embodiments of the present invention will be described below with reference to the accompanying drawings.

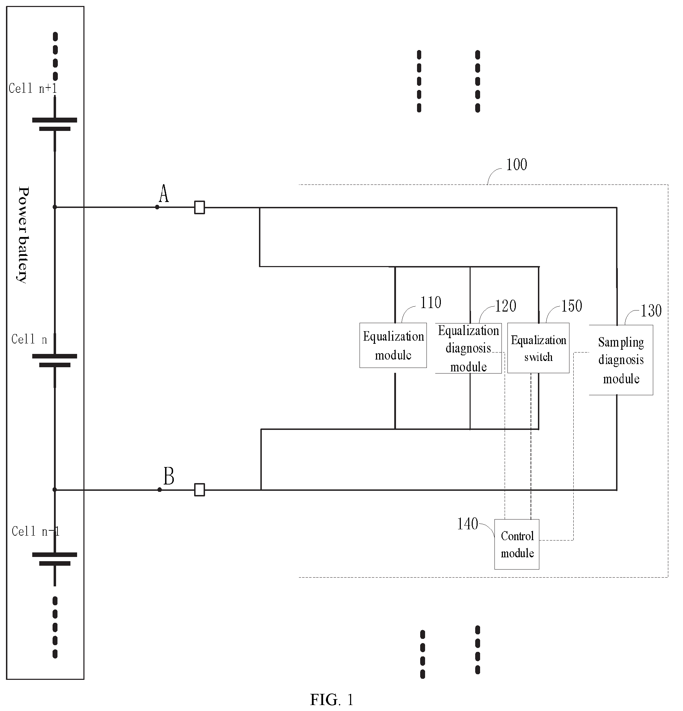

FIG. 1 is a block diagram of the diagnosis circuit for a power battery provided in embodiments of the present invention.

As shown in FIG. 1, the diagnosis circuit 100 for a power battery in the embodiments of the present invention includes: an equalization module 110, an equalization diagnosis module 120, a sampling diagnosis module 130 and a control module 140. The equalization module 110 and the equalization diagnosis module 120 are both connected in parallel with an equalization switch 150 in an equalization circuit. The control module 140 is connected to the equalization switch 150, the equalization diagnosis module 120, and the sampling diagnosis module 130. The control module 140 is configured to, during line diagnosis: control the equalization switch 150 to be in a connected state, such that the equalization module 110 discharges; control the equalization switch 150 to be disconnected after the equalization switch 150 remains in the connected state for a first preset time; and control the equalization diagnosis module 120 and the sampling diagnosis module 130 to perform line diagnosis on a sampling branch and the equalization circuit.

Specifically, as shown in FIG. 1, the diagnosis circuit 100 for a power battery is connected to two terminals of an n-th battery cell in the power battery via a sampling line A and a sampling line B. The sampling diagnosis module 130 may sample the voltage across the battery cell through the sampling line A and the sampling line B, and transmit the sampled value to the battery management system (BMS) to which the battery cell corresponds. The BMS determines whether equalization is required based on the voltage value of each battery cell. When a surge on the power battery bus is coupled to the sampling line A and further transmitted to the sampling diagnosis module 130, it may cause the battery cell to falsely report overvoltage or undervoltage faults. In addition, a relatively large surge may create a large voltage difference between the sampling line A and the sampling line B. Since the impedance of the equalization circuit is lower than that of the sampling branch (the equalization circuit has an impedance of several tens of ohms, while the sampling branch has an impedance of several thousand ohms), the surge preferentially flows through the equalization circuit. As a result, the equalization switch 150 is at a relatively high risk of breakdown. However, the equalization module 110 is capable of absorbing the high surge voltage, thereby preventing the sampling diagnosis module 130 from experiencing sampling instability and avoiding the breakdown of the equalization switch 150.

When line diagnosis is performed to determine whether an open-circuit fault is present, the control module 140 controls the equalization switch 150 to be connected, such that electric charge stored in the equalization module 110 is discharged via the equalization switch 150. After the equalization switch 150 remains in the connected state for a first preset time, the control module 140 controls the equalization switch 150 to be disconnected, and then controls the equalization diagnosis module 120 to perform line diagnosis on the equalization circuit to determine whether an open-circuit fault is present in the equalization circuit, and controls the sampling diagnosis module 130 to perform line diagnosis on the sampling branch to determine whether an open-circuit fault is present in the sampling branch.

Thus, during line diagnosis, the diagnosis circuit for a power battery provided in the embodiments of the present invention first enables the equalization module to discharge via the equalization switch, and then performs line diagnosis on the sampling branch and the equalization circuit via the equalization diagnosis module and the sampling diagnosis module. This achieves stable sampling and low cost, shortens the sampling period, and improves protection capability and diagnostic reliability of the cell sampling board.

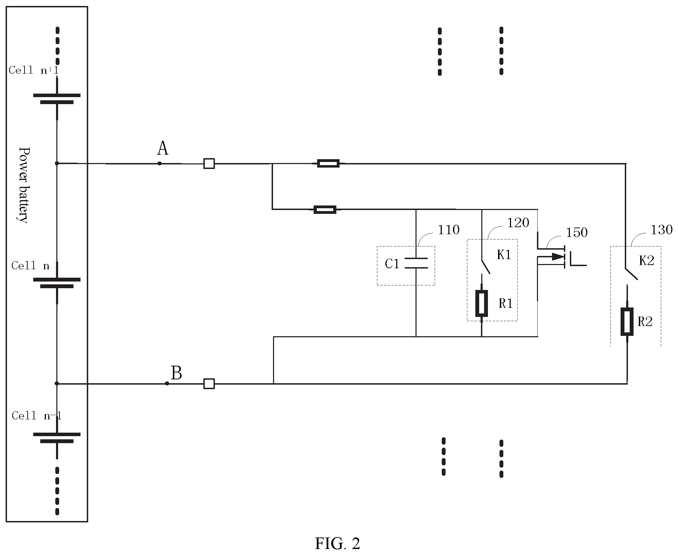

According to an embodiment of the present invention, as shown in FIG. 2, the sampling diagnosis module 130 includes a first switch K1 and a first resistor R1. One end of the first switch K1 is connected to a first sampling point of the sampling branch, and the other end of the first switch K1 is connected to a second sampling point of the sampling branch via the first resistor R1.

According to an embodiment of the present invention, as shown in FIG. 2, the equalization diagnosis module 120 includes a second switch K2 and a second resistor R2 connected in series. One end of the second switch K2 is connected to one end of the equalization switch 150, and the other end of the second switch K2 is connected to the other end of the equalization switch 150 via the second resistor R2.

According to an embodiment of the present invention, the control module 140 is further configured to control the first switch K1 to be in an "on" state, control the second switch K2 to be in an "off" state, and perform line diagnosis based on a voltage value of the first resistor R1.

According to an embodiment of the present invention, the control module 140 is further configured to control the first switch K1 to be in an "off" state, control the second switch K2 to be in an "on" state, and perform line diagnosis based on a voltage value of the second resistor R2.

Specifically, when line diagnosis is performed to determine whether an open-circuit fault is present, the control module 140 controls the equalization switch 150 to be connected, such that the electric charge stored in the equalization module 110 is discharged via the equalization switch 150. After the equalization switch 150 remains in the connected state for a first preset time, the control module 140 controls the equalization switch 150 to be disconnected. When the sampling diagnosis module 130 performs line diagnosis on the sampling branch to determine presence of an open-circuit fault in the sampling branch, the control module 140 controls the first switch K1 to an "on" state and controls the second switch K2 to an "off" state. The control module 140 acquires a voltage value of the first resistor R1, and compares the voltage value of the first resistor R1 with an undervoltage threshold value for an open-circuit fault of the sampling line. When the voltage value of the first resistor R1 is less than the undervoltage threshold value for the open-circuit fault of the sampling line, it is determined that no open-circuit fault is present in the sampling branch. When the voltage value of the first resistor R1 is greater than or equal to the undervoltage threshold value for the open-circuit fault of the sampling line, it is determined that an open-circuit fault is present in the sampling branch.

Further, when the equalization diagnosis module 120 performs line diagnosis on the equalization circuit to determine presence of an open-circuit fault in the equalization circuit, the control module 140 controls the first switch K1 to an "off" state and controls the second switch K2 to an "on" state. The control module 140 acquires a voltage value of the second resistor R2, and compares the voltage value of the second resistor R2 with the undervoltage threshold value for the open-circuit fault. When the voltage value of the second resistor R2 is less than the undervoltage threshold value for the open-circuit fault, it is determined that no open-circuit fault is present in the equalization circuit. When the voltage value of the second resistor R2 is greater than or equal to the undervoltage threshold value for the open-circuit fault, it is determined that an open-circuit fault is present in the equalization circuit. In this way, it is possible to quickly and accurately determine whether an open-circuit fault is present in the sampling branch and the equalization circuit.

According to an embodiment of the present invention, as shown in FIG. 2, the equalization module 110 further includes an equalization capacitor C1. The equalization capacitor C1 is connected in parallel with the equalization switch 150.

According to an embodiment of the present invention, a capacitance value of the equalization capacitor C1 is determined by a surge voltage and heat generated when the surge voltage is applied to the equalization circuit.

Specifically, assuming that the voltage value of the surge voltage is U, the heat generated when the surge voltage is applied to the equalization circuit is W, and the capacitance value of the equalization capacitor C1 is C, where the voltage value U and the heat W can be measured, the capacitance value C of the equalization capacitor C1 may be obtained by substituting the voltage value U and the heat W into the following formula:
$W = \frac{1}{2} {CU}^{2}$*.*

According to an embodiment of the present invention, the first preset time is determined by an internal resistance of the equalization switch 150 and the capacitance value of the equalization capacitor C1.

Specifically, assuming that the internal resistance of the equalization switch 150 is R and the first preset time is t, the specific value of the first preset time t may be obtained by substituting the internal resistance R of the equalization switch 150 and the capacitance value C of the equalization capacitor C1 into the formula: t = 5RC.

According to an embodiment of the present invention, as shown in FIG. 2, the equalization switch 150 is a metal-oxide semiconductor field-effect transistor (MOSFET).

Specifically, the MOSFET has a relatively low on-resistance, typically only several ohms. Therefore, when the equalization switch 150 is connected, the electric charge stored in the equalization module 110 can be rapidly discharged via the equalization switch 150. The discharge time is relatively short, which can shorten the sampling and diagnosis cycle, thereby avoiding significant losses caused by low communication efficiency and untimely fault triggering.

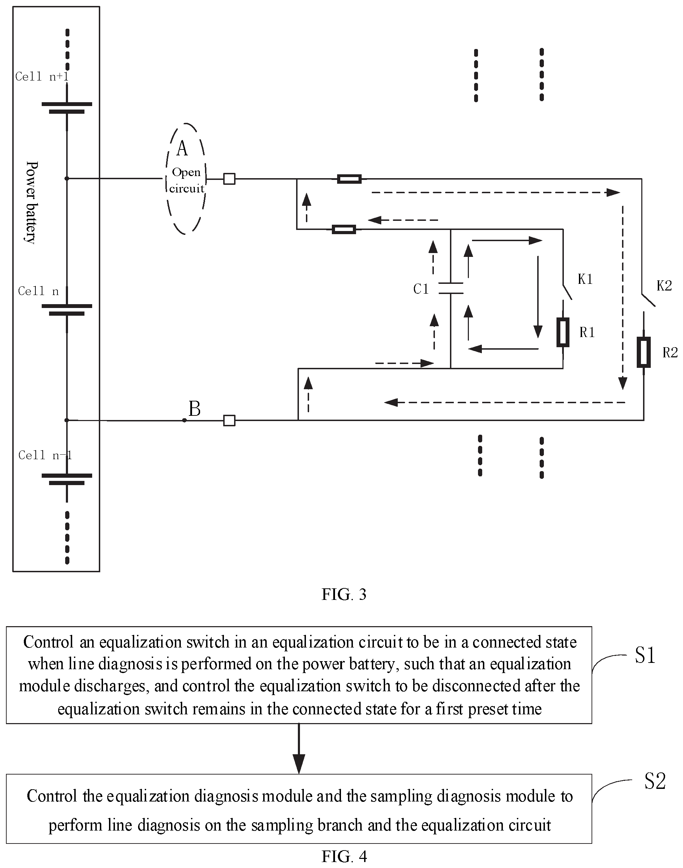

The specific concept of the present invention will be explained in detail below with reference to FIGs. 2 and 3.

As shown in FIG. 2, the diagnosis circuit 100 for a power battery is connected to two terminals of the n-th battery cell in the power battery via a sampling line A and a sampling line B. When a surge on the power battery bus is coupled to the sampling line A and further transmitted to the sampling diagnosis module 130, it may cause the battery cell to falsely report overvoltage or undervoltage faults. In addition, a relatively large surge may create a large voltage difference between the sampling line A and the sampling line B. Since the impedance of the equalization circuit is lower than that of the sampling branch (the equalization circuit has an impedance of several tens of ohms, while the sampling branch has an impedance of several thousand ohms), the surge preferentially flows through the equalization circuit. As a result, the equalization switch 150 (the MOSFET), due to its relatively low withstand voltage, is at a relatively high risk of breakdown. Therefore, an equalization capacitor C1 is generally added between the drain and the source of the MOSFET. However, given the sampling frequency of the chip analog-to-digital converter (ADC) and filtering requirements, the capacitance value of the equalization capacitor C1 is generally selected to be several tens of nanofarads. Nevertheless, such a low capacitance has limited effectiveness in withstanding surges. If the capacitance value of the equalization capacitor C1 is increased to be sufficiently large, it will affect the subsequent open-circuit diagnosis of the sampling branch and the equalization circuit. The specific effects are as follows. FIG. 3 is an equivalent circuit diagram when the equalization switch 150 (the MOSFET) is disconnected during line diagnosis. If the sampling line A has an open-circuit fault, when the sampling diagnosis module 130 performs line diagnosis on the sampling branch, the first switch K1 is "on", the second switch K2 is "off", and the voltage value of the first resistor R1 is read to determine the open-circuit fault. The diagnosis circuit of the sampling branch is shown by the dashed arrow loop in FIG. 3. To meet the requirements for surge immunity and filtering, a relatively large capacitance value is selected for the equalization capacitor C1 based on the surge voltage U and the heat W. However, the equalization capacitor C1 with a relatively large capacitance value stores more electric charge. Consequently, when the equalization capacitor C1 discharges through the first resistor R1 for a certain discharge duration, the voltage across the first resistor R1 remains relatively high, exceeding the undervoltage threshold value for the open-circuit fault of the sampling line, thereby making it impossible to identify the open-circuit fault. Similarly, when the equalization diagnosis module 120 performs line diagnosis on the equalization circuit, the first switch K1 is "off", the second switch K2 is "on", and the voltage value of the second resistor R2 is read to determine the open-circuit fault. The diagnosis circuit of the equalization circuit is shown by the solid arrow loop in FIG. 3. Due to the relatively large capacitance value of the equalization capacitor C1, the voltage across the second resistor R2 also remains relatively high, exceeding the undervoltage threshold value for the open-circuit fault, thereby making it impossible to identify the open-circuit fault. It can thus be seen that, although the relatively large capacitance value of the equalization capacitor C1 solves the problems of device damage and sampling instability caused by surges, it also causes the equalization capacitor C1 to continuously discharge through the first resistor R1 or the second resistor R2 during the open-circuit diagnosis of the sampling branch and the equalization circuit. This results in a relatively high voltage across the first resistor R1 or the second resistor R2 and a prolonged discharge time, which prevents the diagnosis circuit from detecting the open-circuit fault within the required period, thereby leading to low communication efficiency and delayed fault triggering, and potentially causing significant losses.

In contrast, in the diagnosis circuit 100 for a power battery provided in the present invention, an equalization capacitor C1 with a large capacity is provided. The capacitance value of the equalization capacitor C1 is determined by the surge voltage and the heat generated when the surge voltage is applied to the equalization circuit. This capacitance value is much higher than that of a normal filter capacitor, with a capacitance difference between the two on the order of tens to one hundred times. When line diagnosis is performed on the power battery, the equalization switch 150 in the equalization circuit is first controlled to be in a connected state such that the equalization module 110 discharges, enabling rapid discharging of the electric charge in the equalization capacitor C1. After the equalization switch 150 remains in the connected state for a first preset time, the equalization switch 150 is controlled to be disconnected. The first preset time is determined by the internal resistance of the equalization switch 150 and the capacitance value of the equalization capacitor C1. Then, the equalization diagnosis module 120 and the sampling diagnosis module 130 are controlled to perform line diagnosis on the sampling branch and the equalization circuit. Different from existing technical solutions in which a transient voltage suppressor (TVS) is added between sampling ports, the diagnosis circuit for a power battery provided in the present invention achieves surge absorption, stable sampling, and low cost. In addition, by adjusting the open-circuit diagnosis methods for the sampling branch and the equalization circuit in terms of control strategy, the problem that the open-circuit fault cannot be diagnosed within a short period due to the relatively large capacitance value of the equalization capacitor C1 is solved, and the protection capability and diagnostic reliability of the cell sampling board are improved.

In summary, in the diagnosis circuit for a power battery provided in the embodiments of the present invention, during line diagnosis, the control module controls the equalization switch to be in a connected state such that the equalization module discharges, then controls the equalization switch to be disconnected after the equalization switch remains in the connected state for a first preset time, and subsequently controls the equalization diagnosis module and the sampling diagnosis module to perform line diagnosis on the sampling branch and the equalization circuit. In this way, during line diagnosis, the circuit first causes the equalization module to discharge via the equalization switch, and then perform line diagnosis on the sampling branch and the equalization circuit via the equalization diagnosis module and the sampling diagnosis module. This achieves stable sampling and low cost, shortens the sampling period, and improves protection capability and diagnostic reliability of the cell sampling board.

Corresponding to the above embodiments, the present invention further provides a control method for a diagnosis circuit for a power battery.

FIG. 4 is a flowchart of a control method for a diagnosis circuit for a power battery provided in an embodiment of the present invention.

As shown in FIG. 4, the control method for the diagnosis circuit for a power battery provided in an embodiment of the present invention may include the following steps S1 and S2.

In step S1, when line diagnosis is performed on the power battery, an equalization switch in an equalization circuit is controlled to be in a connected state such that an equalization module discharges; and after the equalization switch remains in the connected state for a first preset time, the equalization switch is controlled to be disconnected.

In step S2, an equalization diagnosis module and a sampling diagnosis module are controlled to perform line diagnosis on a sampling branch and an equalization circuit.

According to an embodiment of the present invention, the above method further includes: controlling a first switch to be in an "on" state, controlling a second switch to be in an "off" state, and performing line diagnosis based on a voltage value of a first resistor.

According to an embodiment of the present invention, the above method further includes: controlling the first switch to be in an "off" state, controlling the second switch to be in an "on" state, and performing line diagnosis based on a voltage value of a second resistor.

It should be noted that, for details not disclosed in the control method for the diagnosis circuit for a power battery provided in the embodiments of the present invention, reference may be made to the details disclosed in the diagnosis circuit for a power battery provided in the embodiments of the present invention, and details will not be repeated herein.

According to the control method for the diagnosis circuit for a power battery provided in the embodiments of the present invention, when line diagnosis is performed on the power battery of a sampling branch, the equalization switch in the equalization circuit is first controlled to be in a connected state, such that the equalization module discharges; the equalization switch of the sampling branch is then controlled to be disconnected after the equalization switch of the sampling branch remains in the connected state for a first preset time; and subsequently, the equalization diagnosis module and the sampling diagnosis module are controlled to perform line diagnosis on the sampling branch and the equalization circuit of the sampling branch. In this way, through the method, during line diagnosis, the equalization module is discharged via the equalization switch, and then line diagnosis is performed on the sampling branch and the equalization circuit via the equalization diagnosis module and the sampling diagnosis module. This achieves stable sampling and low cost, shortens the sampling period, and improves protection capability and diagnostic reliability of the cell sampling board.

Corresponding to the above embodiments, the present invention further provides a power battery.

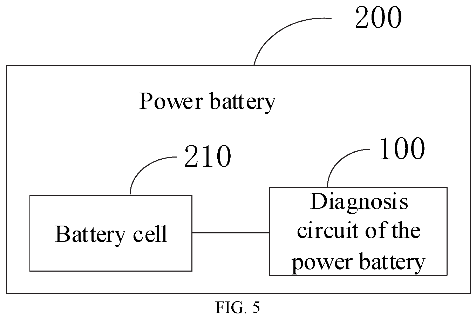

FIG. 5 is a block diagram of a power battery provided in an embodiment of the present invention.

As shown in FIG. 5, the power battery 200 provided in an embodiment of the present invention includes at least one battery cell 210 and an above-described diagnosis circuit 100 correspondingly arranged for each of the at least one battery cell 210.

With the above diagnosis circuit, the power battery according to the embodiments of the present invention, during line diagnosis, first causes the equalization module to discharge via the equalization switch, and then performs line diagnosis on the sampling branch and the equalization circuit via the equalization diagnosis module and the sampling diagnosis module. This achieves stable sampling and low cost, shortens the sampling period, and improves protection capability and diagnostic reliability of the cell sampling board.

It should be noted that the logic and/or steps represented in the flowcharts or otherwise described herein, for example, may be considered as a sequenced list of executable instructions for implementing logical functions, and may be embodied in any computer-readable medium for use by or for use in connection with an instruction execution system, apparatus, or device (such as a computer-based system, a system including a processor, or other systems that can fetch and execute instructions from an instruction execution system, apparatus, or device). For the purposes of this specification, a "computer-readable medium" may be any means that can contain, store, communicate, propagate, or transmit programs for use by or for use in connection with an instruction execution system, apparatus, or device. More specific examples (non-exhaustive) of the computer-readable medium include the following: an electrical connection having one or more wires (electronic device), a portable computer diskette (magnetic device), a random access memory (RAM), a read-only memory (ROM), an erasable programmable read-only memory (EPROM or flash memory), an optical fiber device, and a portable compact disc read-only memory (CD-ROM). In addition, the computer-readable medium may even be paper or another suitable medium on which the programs are printed, as the programs may be electronically obtained by, for example, optically scanning the paper or other medium, followed by editing, interpreting, or otherwise processing it in a suitable manner, and then stored in a computer memory.

It should be understood that various parts of the present invention may be implemented in hardware, software, firmware, or a combination thereof. In the above embodiments, a plurality of steps or methods may be implemented in software or firmware stored in a memory and executed by a suitable instruction execution system. For example, if implemented in hardware, as in another embodiment, it may be implemented using any one or a combination of the following techniques known in the art: discrete logic circuits having logic gate circuits for implementing logic functions on data signals, application-specific integrated circuits having suitable combinational logic gate circuits, programmable gate arrays (PGAs), field programmable gate arrays (FPGAs), etc.

In this specification, descriptions with reference to the terms "one embodiment", "some embodiments", "example", "specific example", or "some examples" mean that specific features, structures, materials, or characteristics described in connection with the embodiment or example are included in at least one embodiment or example of the present invention. In this specification, the schematic descriptions of the above terms do not necessarily refer to the same embodiment or example. Moreover, the specific features, structures, materials, or characteristics described may be combined in any suitable manner in any one or more embodiments or examples.

Furthermore, the terms "first" and "second" are used for descriptive purposes only and should not be construed as indicating or implying relative importance or implicitly indicating the number of a technical feature indicated. Therefore, a feature defined with "first" and "second" may explicitly or implicitly include at least one said feature. In the description of the present invention, "a plurality of" means at least two, such as two, three, etc., unless otherwise expressly and specifically defined.

In the present invention, unless otherwise expressly specified and limited, terms such as "mounted", "connected", "connection", and "fixed" should be interpreted in a broad sense. For example, a connection may be a fixed connection, a detachable connection, or an integral connection; a mechanical connection or an electrical connection; a direct connection or an indirect connection via intervening media; or an internal communication between two elements or an interaction relationship between two elements, unless otherwise expressly limited. For those skilled in the art, specific meanings of the above terms in the present invention may be interpreted according to specific circumstances.

Although embodiments of the present invention have been shown and described above, it should be appreciated that the above embodiments are exemplary and should not be construed as limiting the present invention, and those skilled in the art may make changes, modifications, substitutions, and variations to the above embodiments within the scope of the present invention.

## Claims

1. A diagnosis circuit for a power battery, comprising an equalization module, an equalization diagnosis module, a sampling diagnosis module, and a control module, wherein the equalization module and the equalization diagnosis module are both connected in parallel with an equalization switch in an equalization circuit, and the control module is connected to the equalization switch, the equalization diagnosis module, and the sampling diagnosis module, wherein:
the control module is configured to, during line diagnosis, control the equalization switch to be in a connected state such that the equalization module discharges, control the equalization switch to be disconnected after the equalization switch remains in the connected state for a first preset time, and control the equalization diagnosis module and the sampling diagnosis module to perform line diagnosis on a sampling branch and the equalization circuit.

2. The diagnosis circuit for a power battery according to claim 1, wherein the sampling diagnosis module comprises a first switch and a first resistor, wherein:
one end of the first switch is connected to a first sampling point of the sampling branch, and the other end of the first switch is connected to a second sampling point of the sampling branch via the first resistor.

3. The diagnosis circuit for a power battery according to claim 2, wherein the equalization diagnosis module comprises a second switch and a second resistor connected in series, wherein:
one end of the second switch is connected to one end of the equalization switch, and the other end of the second switch is connected to the other end of the equalization switch via the second resistor.

4. The diagnosis circuit for a power battery according to claim 3, wherein the control module is further configured to control the first switch to be in an "on" state, control the second switch to be in an "off" state, and perform line diagnosis based on a voltage value of the first resistor.

5. The diagnosis circuit for a power battery according to claim 3, wherein the control module is further configured to control the first switch to be in an "off" state, control the second switch to be in an "on" state, and perform line diagnosis based on a voltage value of the second resistor.

6. The diagnosis circuit for a power battery according to claims 1 to 5, wherein the equalization module comprises an equalization capacitor connected in parallel with the equalization switch.

7. The diagnosis circuit for a power battery according to claim 6, wherein a capacitance value of the equalization capacitor is determined by a surge voltage and heat generated when the surge voltage is applied to the equalization circuit.

8. The diagnosis circuit for a power battery according to claim 6, wherein the first preset time is determined by an internal resistance of the equalization switch and a capacitance value of the equalization capacitor.

9. The diagnosis circuit for a power battery according to claim 1, wherein the equalization switch is a metal-oxide semiconductor field-effect transistor.

10. A control method for the diagnosis circuit for a power battery according to any one of claims 1 to 9, comprising:
when line diagnosis is performed on the power battery, controlling the equalization switch in the equalization circuit to be in a connected state such that the equalization module discharges, and controlling the equalization switch to be disconnected after the equalization switch remains in the connected state for the first preset time; and
controlling the equalization diagnosis module and the sampling diagnosis module to perform line diagnosis on the sampling branch and the equalization circuit.

11. A power battery, comprising at least one battery cell and a diagnosis circuit according to any one of claims 1 to 9 correspondingly arranged for each of the at least one battery cell.
